# EUROPÄISCHE PATENTSCHRIFT

(11) **EP 1 216 435 B1**
(45) Veröffentlichungstag und Bekanntmachung des Hinweises auf die Patenterteilung: **29.06.2005**
(21) Anmeldenummer: 00958428.5
(22) Anmeldetag: 11.08.2000
(51) Int. Cl.: G03F 7/20

(54) **VERFAHREN ZUR SYNCHRONISATION VON POSITIONIER- UND BELICHTUNGSVORGÄNGEN**
METHOD FOR SYNCHRONISING POSITIONING AND EXPOSURE PROCESSES
PROCEDE PERMETTANT DE SYNCHRONISER DES PROCESSUS DE POSITIONNEMENT ET D'EXPOSITION

(30) Priorität: 17.09.1999 DE 19944759
(43) Veröffentlichungstag der Anmeldung: 26.06.2002
(73) Patentinhaber: Basys Print GmbH Systeme für die Druckindustrie, 19258 Boizenburg (DE); Toyo Ink. MFG. Co. Ltd., Tokyo 173-8666 (JP)
(72) Erfinder: EGGERS, Stefan, 21465 Wentorf (DE); ANDREAE, Claas, 21382 Brietlingen (DE)
(74) Vertreter: Vonnemann, Gerhard, Dr.-Ing.
(86) Internationale Anmeldenummer: PCT/EP2000/007840
(87) Internationale Veröffentlichungsnummer: WO 2001/022167

(56) Entgegenhaltungen:
- EP-A- 0 845 710
- WO-A-95/22787
- US-A- 5 523 193
- US-A- 5 691 541
- PAUFLER J ET AL: "HIGH-THROUGHPUT OPTICAL DIRECT WRITE LITHOGRAPHY" SOLID STATE TECHNOLOGY,COWAN PUBL.CORP. WASHINGTON,US, Bd. 40, Nr. 6, 1. Juni 1997 (1997-06-01), Seiten 175-176,178,180, XP000656405 ISSN: 0038-111X

## Beschreibung

Die Erfindung betrifft ein Verfahren zur Belichtung von Druckmedien, insbesondere von Druckplatten, mittels Licht, insbesondere UV-Licht, aus einer Lichtquelle, welches durch eine Projektionseinheit verändert wird, insbesondere in der Richtung und/oder der Intensität, wobei in einem ersten Prozeß auf dem Druckmedium eine Abbildung eines berechneten und gespeicherten Teilbildes aus der Projektionseinheit entsteht und durch einen zweiten Prozeß mittels einer Positioniereinheit ein Positionieren der Projektionseinheit relativ zum Druckmedium erfolgt.

Eine derartige Belichtungsvorrichtung, die zur Belichtung von Druckplatten mit ultraviolettem Licht verwendet wird, ist beispielsweise aus der WO 95/22787 bekannt. Dabei wird die abzubildende Vorlage mittels eines Computers in Teilbilder zerlegt und die Teilbilder nacheinander auf einen elektronisch ansteuerbaren Lichtmodulator, beispielsweise einen durchstrahlten LCD-Bildschirm dargestellt. Die Belichtungsvorrichtung wird dann nach und nach über die zu belichtende Druckplatte bewegt, wobei der Lichtmodulator jeweils mit dem zugehörigen Teilbild angesteuert wird.

Aus der US 5,523,193 ist eine Belichtungsvorrichtung bekannt, bei der das Auf eine Unterlage zu belichtende Bild mittels eines Computers spaltenweise zerlegt und auf eine rechteckigen Modulator mit mehreren Spalten gegeben wird. Zur Belichtung eines ganzen Bildes wird die Unterlage quer zur Spaltenrichtung kontinuierlich verschoben und gleichzeitig der Bildinhalt auf dem Modulator von einer Spalte zur jeweils benachbarten Spalte übertragen, so daß die vorherige Spalte einen neuen Bildinhalt aufnehmen kann, bis das gesamte Bild abgearbeitet ist.

Andere bekannte digitale Belichter verwenden das DSI-Verfahren (Digital-Screen-Imaging) für die Ansteuerung eines LCD zur Bilderzeugung in einem Belichtungsapparat. Das DSI-Verfahren basiert auf einer Matrix aus gitterförmig angeordneten Punkten, wobei jeder einzelne Punkt dieser Lichtmatrix einzeln angesteuert werden kann, so daß Licht aus der Lichtquelle transmittiert oder absorbiert wird. Die Projektion dieser Matrix auf das zu belichtende Medium ergibt je nach gewähltem Vergrößerungsverhältnis der Abbildungseinheit eine beleuchtete Fläche von 0,5 bis zu einigen Quadratzentimetern.

Größere Flächen werden belichtet, indem das Bild zunächst in Teilbilder zerlegt wird. Die Teilbilder werden von der Projektionseinheit sequentiell auf den zu belichtenden Träger abgebildet, wobei die Projektionseinheit in Schritten bewegt und jedes Teilbild auf das zu belichtende Medium projiziert wird. Das Aneinanderfügen dieser Teilbilder erfolgt mit einer hohen Präzision, so daß keine Trennlinien zwischen den einzelnen Teilbildern sichtbar werden. Typisch sind Genauigkeiten von <2µm, da andernfalls das Auge sehr empfindlich auf sich sonst ergebende Muster reagiert.

Die Steuerung des Belichters wird von einer rechnerbasierten Steuersoftware übernommen. Diese Software versorgt zum einen über die Grafikkarte die digitale Lichtmatrix mit der nötigen Bildinformation und zum anderen über ein Feldbussystem die Positioniereinheit mit der nötigen Ortsinformation.

Das DSI-Verfahren beinhaltet, wie jedes andere Direktbelichtungsverfahren, einen seriellen Prozeß. Unterschiedliche Bereiche des zu bebildernden Materials werden zu unterschiedlichen Zeiten belichtet. Spezifisch für das DSI-Verfahren ist allerdings, daß zwischen den reinen Belichtungszeiten und den Positionierzeiten keine Abhängigkeit besteht.

Bei laserbasierten scannenden Belichtern ist die Ablenkgeschwindigkeit gekoppelt mit der Belichtungszeit. Beim DSI-Verfahren ist die Positionierzeit eine maschinentypische Konstante, während die Belichtungszeit durch die Verweildauer zwischen zwei Positioniervorgängen eingestellt wird.

Bei der Erstellung von Druckschriften, besonders bei Tageszeitungen, ist die Erstellung der Druckplatten besonders zeitkritisch, da bis in die letzten Minuten vor dem Druck noch Informationen mitgedruckt werden sollen. Es ist also wünschenswert, die Erstellung der Druckplatten möglichst weit nach hinten zu verschieben.

Aufgabe der Erfindung ist es daher, ein Verfahren anzugeben, das den Herstellungsprozeß von Druckschriften beschleunigt.

Die Aufgabe der Erfindung wird dadurch gelöst, daß ein Aneinanderfügen von Teilbildern zu einer Abbildung optimiert wird, indem der erste Prozeß und der zweite Prozeß parallel erfolgen, daß die Koordination des ersten Prozesses mit dem zweiten Prozeß durch eine übergeordnete Einheit über Steuerleitungen erfolgt und daß mindestens eine Einheit vorgesehen ist, in der ein oder mehrere Triggersignale generiert werden, insbesondere für Start und Ende des zweiten Prozesses zum Verfahren der Projektionseinheit zum nächsten Teilbild und für den ersten Prozeß, insbesondere für Start und Ende der Belichtung, wobei die Triggersignale von einer Empfangseinheit, insbesondere der übergeordneten Einheit, ausgewertet werden. Bisher wurden die Druckplatten bei ähnlichen Verfahren in sequentiellen Teilschritten ausgeführt, die noch dazu an einen festen Systemtakt gebunden waren. Dadurch entstehen bei jeder Teilbildberechnung deutliche Zeitverluste. Durch die parallele Verarbeitung der Prozesse ist eine Optimierung der Herstellungszeit ohne großen technischen Aufwand, wie zum Beispiel eine schnellere Positionierungseinheit oder eine schnellere Recheneinheit, durchzuführen.

Die Erfindung ermöglicht es, die Bilddaten schon während der Positionierung zu verarbeiten und somit eine unmittelbare Belichtung des Druckmediums nach der genauen Positionierung der Projektionseinheit durchzuführen, wobei die übergeordnete Einheit zusammen mit den Triggersignalen die feste Verknüpfung der Prozesse mit einem Systemtakt entbehrlich macht. Der Ablauf kann an Bedingungen geknüpft werden und muß nicht in Zyklen aufgeteilt werden. Damit können die Positionierungs- und Belichtungsvorgänge einer Plausibilitätsüberwachung und einfacheren Kontrolle unterzogen werden. Die Systemsicherheit spielt bei der heutigen Zeitorientiertheit und der Notwendigkeit, in letzter Sekunde verlässliche Ergebnisse zu erzielen, eine immer ausschlaggebendere Rolle. Überwachungsfunktionen und Anzeige des Belichtungsfortschrittes sind nur zwei der möglichen Anwendungsbeispiele.

Ein einer bevorzugten Ausgestaltungsform der Erfindung werden die Triggersignale von der Positioniervorrichtung und der Projektionseinheit generiert und von diesen über eine Meldeleitung zur Synchronisation genutzt, wobei vorzugsweise eine Überwachungsleitung von der Meldeleitung zur übergeordneten Einheit angebracht wird. Auf diese Weise ist die Synchronisation nicht an ein Protokoll oder an feste Systemtakte gebunden. Statt dessen wird der Ablauf von den Prozessen selbst gesteuert. Es bietet sich weiterhin die Möglichkeit der Integration einer Bedienerschnittstelle in die übergeordnete Steuerung. Somit wird die Einbindung von Standardkomponenten von Betriebssystemen und Programmierhilfen realisierbar.

Als weitere Ausgestaltungsform ist vorgesehen, daß die Teilbilder für die Projektionseinheit zur Veränderung des Lichtes aus der Lichtquelle während der Positionierung der Projektionseinheit berechnet werden. In dieser Zeit der Positionierung geht sonst wertvolle Zeit verloren, die hier zum Berechnen der nächsten anzuzeigenden Bilddaten, zur Bildspeicherung und zur Ansteuerung der Projektionseinheit genutzt wird.

Weiterhin ist vorgesehen, daß jedes Teilbild in der Projektionseinheit zwischengespeichert wird, bis das Triggersignal für Ende des Positionierens gesendet wird. Durch diese Ausgestaltung der Erfindung wird der Zeitbedarf des gesamten Verfahrens optimiert, da direkt nach der Positionierung das gespeicherte Teilbild angezeigt werden kann und die nächste Position angesteuert werden kann. Die Einsparungen pro Teilbilderzeugung können 21 bis 42 ms betragen.

Als weitere Ausgestaltungsform ist vorgesehen, daß ein leeres Teilbild von der übergeordneten Einheit erkannt und übergangen wird. Viele Drucksachen weisen nur eine Schwärzung von 5% auf, wie Sie dem Dr. Grauert-Brief entspricht. Ein weißes Teilbild wird dann übersprungen und die Positionierung wird direkt mit dem nächsten Teilbild fortgesetzt. Die Beschleunigungsvorgänge der Positioniereinheit sind daher deutlich reduziert. Da bei der Erzeugung der Teilbilder oft ein weißes Teilbild vorkommt, kann durch diese Maßnahme die Zeit für den Belichtungsjob weiter reduziert werden.

Die Erfindung wird in einer bevorzugten Ausführungsform unter Bezugnahme auf eine Zeichnung beschrieben, wobei weitere vorteilhafte Einzelheiten den Figuren der Zeichnung zu entnehmen sind. Funktionsmäßig gleiche Teile sind dabei mit denselben Bezugszeichen versehen.

Es zeigen:
- Fig. 1:: Schematische Darstellung der Steuerungseinheiten;
- Fig. 2:: Schematische Darstellung der Prozesse Positionierung und Teilbilderzeugung.

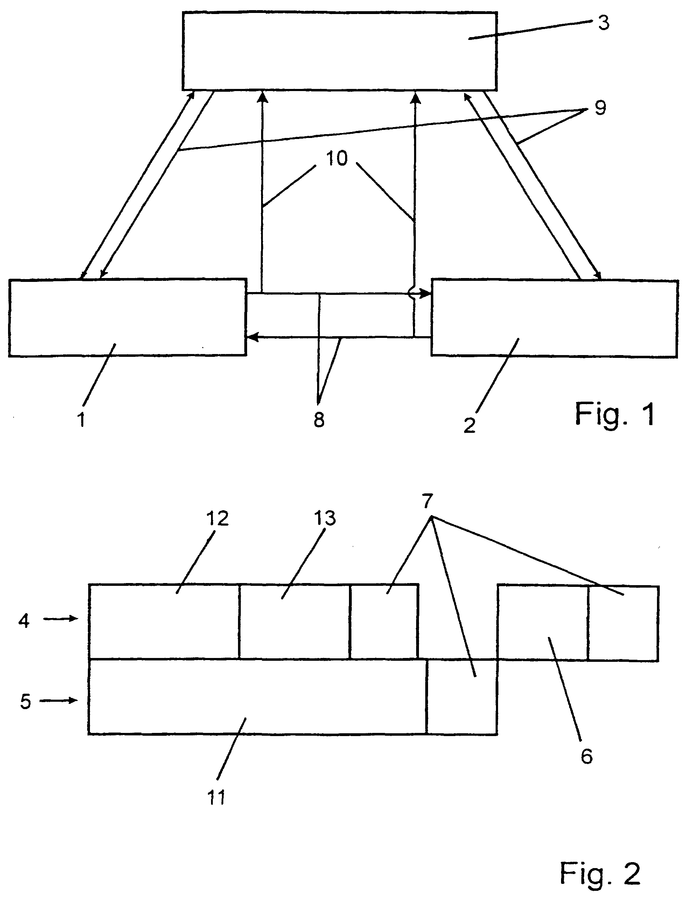

In Figur 1 sind die Steuereinheiten des Belichters in einer möglichen Ausführungsform dargestellt. Die übergeordnete Einheit 3 hat eine überwachende und steuernde Funktion. Sie koordiniert und synchronisiert den Ablauf der Bilderzeugung durch die untergeordneten Einheiten zur Positionierung und Belichtung. Die Informationsverteilung an die beiden untergeordneten Einheiten Positioniereinheit 1 und Projektionseinheit 2 muß durch die übergeordnete Einheit 3 erfolgen, die den gesamten Belichtungsjob kennt und verwaltet. In einer einfachen Ausführungsform des Verfahrens, dargestellt durch die dünnen, gestrichelten Steuerleitungen 9, ist diese Instanz außerdem für die Synchronisation dieser beiden Prozesse verantwortlich, also Belichtungs- und Positionierstart zu initiieren und Belichtungs- und Positionierende zu detektieren. Bedingt durch die Kommunikationszeiten z. b. im verwendeten Feldbussystem, können bei diesen Synchronisationsaufgaben mehrere ms pro Teilbildbelichtung nötig sein, die sich bei mehreren tausend Teilbildbelichtungen zu nennenswerten Einsparpotentialen summieren.

In einer optimierten Ausführungsform, dargestellt durch die zusätzlichen Meldeleitungen 8 und Überwachungsleitungen 10 erfolgt die Synchronisation über eigene Meldeleitungen 8 zwischen Positioniereinheit 1 und Projektionseinheit 2, so daß diese an kein Protokoll oder feste Systemtakte gebunden ist. Die übergeordnete Einheit 3 erhält lediglich Nachrichten über Belichtungs- und Positionierstarts mittels Triggersignalen 7, um eine Plausibilitätsüberwachung zu gewährleisten.

In der Figur 2 sind die Prozesse Positionierung und Teilbilderzeugung schematisch dargestellt. Während der genauen Positionierung der Projektionseinheit 2 an die Stelle des ersten Teilbildes 6, findet parallel hierzu die Berechnung des Bildinhaltes des ersten Teilbildes 6 statt. Nach der Berechnung wird ein Triggersignal 7 zum Anzeigen des Endes der Teilbildberechnung ausgegeben. Dieses Triggersignal 7 wird entweder an die übergeordnete Einheit 3 allein oder in der verbesserten Ausführungsform an die Positioniereinheit 1 und die übergeordnete Einheit 3 übermittelt.

Sobald das Signal für das Ende der Positionierung und das Signal für die beendete Teilbildspeicherung übermittelt sind, wird das Teilbild 6 von der Projektionseinheit 2 angezeigt. Sobald das Triggersignal 7 für das Belichtungsende gesendet wird, beginnt die Positionierung und die Teilbildberechnung für das nächste Teilbild 6.

### Bezugszeichenliste

- 1: Positioniereinheit
- 2: Projektionseinheit
- 3: übergeordnete Einheit
- 4: erster Prozeß
- 5: zweiter Prozeß
- 6: Teilbild
- 7: Triggersignal
- 8: Meldeleitung
- 9: Steuerleitung
- 10: Überwachungsleitung

## Patentansprüche

1. Verfahren zur Belichtung von Druckmedien, insbesondere von Druckplatten, mittels Licht, insbesondere UV-Licht, aus einer Lichtquelle, welches durch eine Projektionseinheit (2) verändert wird, insbesondere in der Richtung und/oder der Intensität, wobei in einem ersten Prozeß (4) auf dem Druckmedium eine Abbildung eines berechneten (12) und gespeicherten (13) Teilbildes (6) aus der Projektionseinheit (2) entsteht und durch einen zweiten Prozeß (5) mittels einer Positioniereinheit (1) ein Positionieren (11) der Projektionseinheit (2) relativ zum Druckmedium erfolgt, **dadurch gekennzeichnet, daß** ein Aneinanderfügen von Teilbildern (6) zu einer Abbildung optimiert wird, indem der erste Prozeß (4) und der zweite Prozeß (5) parallel erfolgen, daß die Koordination des ersten Prozesses (4) mit dem zweiten Prozeß (5) durch eine übergeordnete Einheit (3) über Steuerleitungen (9) erfolgt und daß mindestens eine Einheit vorgesehen ist, in der ein oder mehrere Triggersignale (7) generiert werden, insbesondere für Start und Ende des zweiten Prozesses (5) zum Verfahren der Projektionseinheit (2) zum nächsten Teilbild (6) und für den ersten Prozeß (4), insbesondere für Start und Ende der Belichtung, wobei die Triggersignale (7) von der übergeordneten Einheit (3) ausgewertet werden.

2. Verfahren nach Anspruch 1, **dadurch gekennzeichnet, daß** die Triggersignale (7) von der Positioniereinheit (1) und der Projektionseinheit (2) generiert werden und von diesen über mindestens eine Meldeleitung (8) zur Synchronisation genutzt werden, wobei vorzugsweise eine Überwachungsleitung (10) von der Meldeleitung (8) zur übergeordneten Einheit (3) angebracht wird.

3. Verfahren nach Anspruch 1 oder 2, **dadurch gekennzeichnet, daß** die Teilbilder (6) für die Projektionseinheit (2) zur Veränderung des Lichtes aus der Lichtquelle während der Positionierung der Projektionseinheit (2) berechnet werden.

4. Verfahren nach Anspruch 1, 2 oder 3, **dadurch gekennzeichnet, daß** jedes Teilbild (6) in der Projektionseinheit (2) zwischengespeichert wird, bis das Triggersignal (7) für Ende der Positionierung gesendet wird.

5. Verfahren nach Anspruch 1, 2, 3 oder 4, **dadurch gekennzeichnet, daß** ein leeres Teilbild (6) von der übergeordneten Einheit (3) erkannt und übergangen wird.

## Claims

1. A method for exposure of print media, in particular printing plates, by way of light, in particular UV light, from a light source, said light being changed by a projection unit (2), in particular in direction and/or intensity, wherein in a first process (4) an image of a computed (12) and stored (13) part-picture (6) from the projection unit (2) arises on the print medium, and in a second process (5) by way of a positioning unit (1), a positioning (11) of the projection unit (2) relative to the print medium is effected, **characterised in that** a joining-together of part-pictures (6) into an image is optimised **in that** the first process (4) and the second process (5) are effected in parallel, that the coordination of the first process (4) with the second process (5) is effected by way of a super-ordinate unit (3) via control leads (9), and that at least one unit is provided in which one or more trigger signals (7) are generated, in particular for the start and end of the second process (5) for displacing the projection unit (2) to the next part-picture (6), and for the first process (4), in particular for the start and end of the exposure, wherein the trigger signals (7) are evaluated by the super-ordinate unit (3).

2. A method according to claim 1, **characterised in that** the trigger signals (7) are generated by the positioning unit (1) and the projection unit (2) and are used by these via at least one signal lead (8) for synchronisation, wherein preferably a monitoring lead (10) is attached from the signal lead (8) to the super-ordinate unit (3).

3. A method according to claim 1 or claim 2, **characterised in that** the part-pictures (6) for the projection unit (2) for changing the light from the light source are computed during the positioning of the projection unit (2).

4. A method according to claim 1, 2 or 3, **characterised in that** each part-picture (6) is intermediately stored in the projection unit (2) until the trigger signal (7) for the end of the positioning is sent.

5. A method according to claim 1, 2, 3 or 4, **characterised in that** an empty part-picture (6) is recognised by the super-ordinate unit (3) and skipped.

## Revendications

1. Procédé pour insoler des moyens d'impression, notamment des plaques d'impression, par de la lumière en particulier ultra-violette (lumière UV), qui est issue d'une source lumineuse et modifiée par une unité de projection (2) notamment en ce qui concerne sa direction et/ou son intensité, l'unité de projection (2) réalisant dans un premier processus (4), une reproduction d'une partie d'image (6) calculée (12) et mémorisée (13) sur le moyen d'impression, et dans un second processus (5), une unité de positionnement (1) effectuant un positionnement (11) de l'unité de projection (2) par rapport au moyen d'impression,
**caractérisé en ce qu'**
une jonction des images partielles (6) pour aboutir à une reproduction est optimisée en réalisant en parallèle le premier processus (4) et le second processus (5), la coordination de ces processus (4, 5) étant assurée par une unité de supervision (3) au moyen de conducteurs de commande (9), et il est prévu au moins une unité dans laquelle sont générés un ou plusieurs signaux de déclenchement (7), notamment pour le démarrage et la fin du second processus (5), afin de faire passer l'unité de projection (2) à l'image partielle suivante, et pour le premier processus (4), notamment pour le démarrage et la fin de l'insolation, les signaux de déclenchement (7) étant exploités par l'unité de supervision (3).

2. Procédé selon la revendication 1,
**caractérisé en ce que**
les signaux de déclenchement (7) sont générés par l'unité de positionnement (1) et par l'unité de projection (2) et utilisés par ces unités pour la synchronisation par l'intermédiaire d'au moins une ligne d'information (8), avec une ligne de surveillance (10) reliant avantageusement la ligne d'information (8) à l'unité de supervision (3).

3. Procédé selon la revendication 1 ou 2,
**caractérisé en ce que**
les images partielles (6) destinées à l'unité de projection (2) sont calculées pendant le positionnement de cette unité (2) de manière à faire varier la lumière fournie par la source de lumière.

4. Procédé selon la revendication 1, 2 ou 3,
**caractérisé en ce que**
chaque image partielle (6) est mémorisée temporairement dans l'unité de projection (2) jusqu'à ce que soit émis le signal de déclenchement (7) correspondant à la fin du positionnement.

5. Procédé selon la revendication 1, 2, 3 ou 4,
**caractérisé en ce qu'**
une image partielle (6) vide est détectée et effacée par l'unité de supervision (3).
